(19) Europäisches Patentamt
European Patent Office
Office européen des brevets

(11) Publication number: 0 147 196 B1

(12) EUROPEAN PATENT SPECIFICATION

(45) Date of publication of patent specification: 20.09.89

(51) Int. Cl.[4]: H 01 L 29/80, H 01 L 27/08, H 01 L 29/64

(21) Application number: 84308978.0

(22) Date of filing: 20.12.84

# (54) A semiconductor member and semiconductor device employing such a member.

(30) Priority: 23.12.83 JP 242019/83

(43) Date of publication of application: 03.07.85 Bulletin 85/27

(45) Publication of the grant of the patent: 20.09.89 Bulletin 89/38

(84) Designated Contracting States: DE FR GB NL

(56) References cited:
EP-A-0 051 271
EP-A-0 091 831

APPLIED PHYSICS LETTERS, vol. 40, no. 10, May 15, 1982, pages 879-881, American Institute of Physics, New York, US; T.J. DRUMMOND et al.: "Influence AlxGa1-xAs buffer layers on the performance of modulation-doped field-effect transistors"
idem

(73) Proprietor: HITACHI, LTD.
6, Kanda Surugadai 4-chome Chiyoda-ku
Tokyo (JP)

(72) Inventor: Sawada, Yasushi
Dai 2 kyoshin-ryo, 3-1 Higashi-koigakubo
Kokubunji-shi Tokyo (JP)
Inventor: Ueyanagi, Kiichi
3-16-4, Hikari-cho
Kokubunji-shi Tokyo (JP)
Inventor: Katayama, Yoshifumi
1303-9, Shimotomi
Tokorozawa-shi Saitama-ken (JP)
Inventor: Shiraki, Yasuhiro
1-106, 3-26-1, Hirayama
Hino-shi Tokyo (JP)
Inventor: Morioka, Makoto
2196-64, Hirai Hinodemachi
Nishitama-gun Tokyo (JP)
Inventor: Kuroda, Takao
Dai 4 kyoshin-ryo 4-14-6, Nishi-koigakubo
Kokubunji-shi Tokyo (JP)
Inventor: Mishima, Tomoyoshi
1-12-10, Kamimuneoka Shiki-shi
Saitama-ken (JP)

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

EP 0 147 196 B1

Courier Press, Leamington Spa, England.

(56) References cited:
IEEE ELECTRON DEVICE LETTERS, vol. EDL-4, no. 9, September 1983, pages 334-336, IEEE, New York, US; A. KASTALSKY et al.: "Novel real-space hot-electron transfer devices"

IEEE INTERNATIONAL ELECTRON DEVICES MEETING, December 13-15, 1982, San Francisco, CA, US, Technical Digest pages 801-802; T.P. PEARSALL et al.: "Selectively-doped Al0.48In0.52As/Ga0.47In0.52As heterostructure transistors"

JAPANESE JOURNAL OF APPLIED PHYSICS, vol. 21, no. 4, part 2, April 1982, pages L223-L224, Tokyo, JP; R.E. THORNE et al.: "Performance of inverted structure modulation doped schottky barrier field effect transistors"

J.E.E. JOURNAL OF ELECTRONIC ENGINEERING, vol. 20, no. 200, August 1983, pages 60-62, Tokyo, JP; T. MIMURA: "Why HEMT are necessary and how they are made"

(74) Representative: Calderbank, Thomas Roger
MEWBURN ELLIS & CO. 2/3 Cursitor Street
London EC4A 1BQ (GB)

## Description

The present invention relates to a semiconductor member and to a semiconductor device employing such a member.

Prior-art field effect transistors employing heterostructures have basically had energy band structures such as those shown in Fig. 1 or Fig. 2 of the accompanying drawings, or structures in which the positions of two of the semiconductor layers 11 and 12 of the structure of Fig. 1 or Fig. 2 are reversed. In general, one semiconductor layer 11 has a small forbidden band width and a thickness of approximately 0.5 to 1.0 µm, whilst the other semiconductor layer 12 has a large forbidden band width and a thickness of 0.05 to 0.1 µm. In the semiconductor element of Fig. 1 carriers are supplied from the semiconductor layer 12 of large forbidden band width which is doped with n-type impurities (numeral 14 designates donor atoms), whereas in the element of Fig. 2 carriers are supplied from a source electrode. In both cases, however, the carriers 15 are confined within a triangular potential which appears on the side of the hetero-interface closer to the semiconductor layer 11 of small forbidden band width, and they travel to the semiconductor layer 11 which is a layer of high purity. Thus, the carriers are not scattered due to donor inpurity ions 16, and a high mobility may be achieved.

On the other hand, the semiconductor element of Fig. 1 operates as a depletion type transistor (hereinafter abbreviated to "D-type"), being normally conductive because carriers are supplied from donor impurities so that the source and drain of the device are normally connected electronically. In contrast, the device of Fig. 2 operates as an enhancement type transistor (hereinafter abbreviated to "E-type"), being normally nonconductive because carriers are induced into the channel of the element only when a positive voltage is applied to the gate 13 to connect the source and drain of the element. When no voltage is applied to the gate the source and drain are not connected. Therefore, various complications have been necessary if it is wished to form both E-type and D-type elements of the same substrate for the purpose of integration.

In the case of the element shown in Fig. 1, the layer 12 is a thin layer of GaAlAs, doped with n-type impurities to form an E-type element. The reason why an E-type element is formed is as follows. When the GaAlAs layer 12 is thin, the carriers within the GaAlAs layer 12 only are insufficient to form a Schottky contact, and the carriers within the GaAs layer 11 are also used. As a result, the carriers 15 are extinguished within the triangular potential, and carriers are induced only when a positive voltage greater than a threshold voltage is applied to the gate of the element, so that an E-type element is formed. Where the doping concentration of the GaAlAs layer is $2\times10^{18}$ $cm^{-3}$, for example, the device is D-type when the layer 12 has a thickness of 0.07 µm and E-type when the layer 12 has a thickness of 0.06 µm. Therefore, precise etching techniques are required for the GaAlAs layer 12 to form an E-type or a D-type device using the structure shown in Fig. 1. This causes the problems that labour is expended in the manufacture of the element and also the etching must be performed accurately in the thickness direction of the layer.

In the case of the element shown in Fig. 2, donor impurities are introduced into the non-doped GaAlAs layer 12 and carriers are induced in the channel directly under the gate, so that an E-type element can be changed to a D-type element. Here, the processes of diffusion, ion implantation etc. are used to introduce impurities to serve as donors into the GaAlAs layer 12. In any case, however, the distribution of impurities in the thickness direction of the layer assumes a skirt trailing shape, which causes the disadvantage that the donor impurities spread, not only within the GaAlAs layer 12, but also into the layer 11 made of GaAs, so that the mobility of the carriers is reduced.

Also with a semiconductor element of inverse structure in which the positions of the GaAs layer 11 and the GaAlAs layer 12 in Fig. 1 or Fig. 2 are reversed, separate formation of E-type or D-type elements is equally or more difficult. Originally, once the inverse structure of Fig. 1 has been formed, the GaAlAs layer 12 cannot be thinned.

Thus, when it is intended to fabricate an integrated circuit by forming the individual semiconductor elements shown in Fig. 1 or Fig. 2 or having the inverse structure and then making those elements E-type or D-type separately, difficulties occur.

The present invention as defined in the claims seeks to overcome these problems by use of a three layer semiconductor member with the middle layer (first semiconductor layer) being undoped, and the two outer layers having a greater forbidden band width than the middle layer. One of the outer layers, the second semiconductor layer, is doped with impurities whilst the other outer layer, the third semiconductor layer, is undoped.

The expression "undoped" signifies that no impurity is introduced intentionally, and it indicates a state in which the impurity concentration is not higher than approximately $1$—$3\times10^{15}$ $cm^{-3}$.

EP—A—0091831 discloses a semiconductor device having a multi-layer structure with a GaAlAs doped layer, a GaAs doped layer, a GaAs undoped layer, and a GaAlAs doped layer stacked in that order on a semiconductor substrate. The GaAlAs layers have a forbidden band width greater than that of the GaAs layers. Furthermore, there are control electrodes in contact with the GaAlAs layers which control currents flowing in first and second channels formed in the GaAs layer between the GaAlAs layers. The first channel is of depletion type. There is also a pair of ohmic electrodes, the electrodes of the pair being located on either side of the control electrodes. Thus, this document corresponds to the precharacterising part of claim 1.

In EP—A—0091831 both GaAlAs layers are doped, and the ohmic electrodes extend from the GaAlAs layer closest to the substrate to the interface between the undoped GaAs layer and the GaAlAs layer furthest from the substrate. The second channel is also of depletion type and charge carriers have different mobilities in both channels.

The present invention, however, proposes that the semiconductor layer of greater forbidden band width which is furthest from the substrate (the third semiconductor layer) is undoped so that the second channel is of enhancement type, and the at least one pair of ohmic electrodes comprises either a first pair of ohmic electrodes with electrode regions extending from the third semiconductor layer to the first channel, and a second pair of ohmic electrodes with electrode regions extending from the third semiconductor layer to the second channel or electrode regions extending from the third semiconductor layer and connecting both channels in parallel. This makes possible a single semiconductor device with both E-type and D-type channels.

In a device according to the present invention, the at least one control electrode may comprise first and second control electrodes associated respectively with the first and second pairs of ohmic electrodes, each control electrode being on the side of the third semiconductor layer remote from the first semiconductor layer and being between the electrodes of the corresponding pair of ohmic electrodes. Alternatively, there may be one control electrode on the side of the second semiconductor layer remote from the first semiconductor layer for controlling currents flowing within the first channel and one control electrode on the side of the third semiconductor layer remote from the first semiconductor layer for controlling currents flowing within the second channel, each control electrode being located between the electrodes of the corresponding pair of ohmic electrodes.

Embodiments of the invention will now be described in detail, by way of example, with reference to the accompanying drawings, in which:

Fig. 1 and 2 are diagrams of the energy band structure of prior art semiconductor elements and have already been discussed;

Fig. 3 is a diagram of the energy band structure of a semiconductor member according to the present invention;

Fig. 4 is a diagram of the energy band structure of the present invention when control electrodes are provided on both sides of the member;

Figs. 5a and 5b are sectional views showing steps for fabricating an IC according to the present invention; and

Fig. 6 is a sectional view showing a further embodiment of the present invention.

In the following description, GaAlAs will be used as an example of a semiconductor of large forbidden band width, and GaAs as a semiconductor of small forbidden band width. The invention, however, is also applicable to other combinations of materials adapted to form heterojunctions, for example,

$Al_yGa_{1-y}As$-$Al_xGa_{1-x}As$, GaAs-AlGaAsP,

Inp-InGaAsP, InP-InGaAs,

InAs-GaAsSb, and InGaAs-InAlAs.

Referring first to Fig. 3, a semiconductor member according to the present invention has a first semiconductor layer 31 of high purity GaAs with a thickness of 0.3 to 1.0 μm, between a second semiconductor layer 33 of GaAlAs doped with an n-type impurity and a third semiconductor layer 32 of high purity GaAlAs. The GaAlAs layer 33 doped with n-type impurity has a greater forbidden band width than the first layer 31, and the thickness of each GaAlAs layer 32, 33 is approximately 0.5 to 0.1 μm. Channel regions 34, 35 are formed on both sides of the high purity GaAs layer 31. The aluminium content of the GaAlAs layers 32 and 33 need not be equal. The channel region 34 constitutes an E-type element, such as the element of Fig. 2, in which carriers are induced when a positive voltage is applied to a gate electrode 36. The channel region 35 forms a D-type channel because carriers are supplied from the doped GaAlAs layer 33 even when no gate voltage is applied. Accordingly, the elements of both types may be properly used at need.

In the member shown in Fig. 3, the carriers to be induced in the two channels are controlled by the same gate. It is also possible, however, that gate electrodes 36 and 37 may be provided on both sides as shown in Fig. 4, to permit individual control of the carriers of the respective channels.

In each of these members, it is of course possible to use respective elements of E- and D-types separately. Since, however, the elements on both sides can be used in parallel connection by providing a common electrode, the density of integration of the elements may be enhanced. In particular, the structure shown in Fig. 4, has a particularly good density of integration because the carriers of both channels can be controlled individually.

Although only the effects of the fundamental structures in Figs. 3 and 4 have thus far been described, similar effects may be attained with the following structures:

1) A structure wherein, in order to enhance the qualities of the respective semiconductor layers, a high purity GaAs layer (approximately 0.1 μm thick) or/and a high purity GaAlAs layer (approximately 0.1 μm thick) is/are grown on a semiconductor substrate, whereupon the plurality of semiconductor layers shown in Fig. 3 or Fig. 4 are grown on that GaAs layer.

2) A structure in which a GaAs layer approximately 0.01 to 0.1 μm thick is provided on the GaAlAs layer 32 in order to prevent the oxidation of the GaAlAs layer at a front surface.

3) A structure in which a GaAlAs layer of high

purity and approximately 6 nm to 20 nm thick is interposed between the high purity GaAs layer 31 and the n-type GaAlAs layer 33, so that the distances between the carriers travelling through the channel 35 and donor atoms within the GaAlAs layer 33 doped in the n-type is increased, to raise the mobilities of the carriers.

4) A structure which includes any combination of the structures 1) to 3).

As stated above, when the construction as shown in Fig. 3 or Fig. 4 is employed, elements of both E- and D-type can be fabricated and used on the same substrate without requiring precise etching control.

Now, methods of producing semiconductor devices according to the present invention will be described in detail.

Example 1

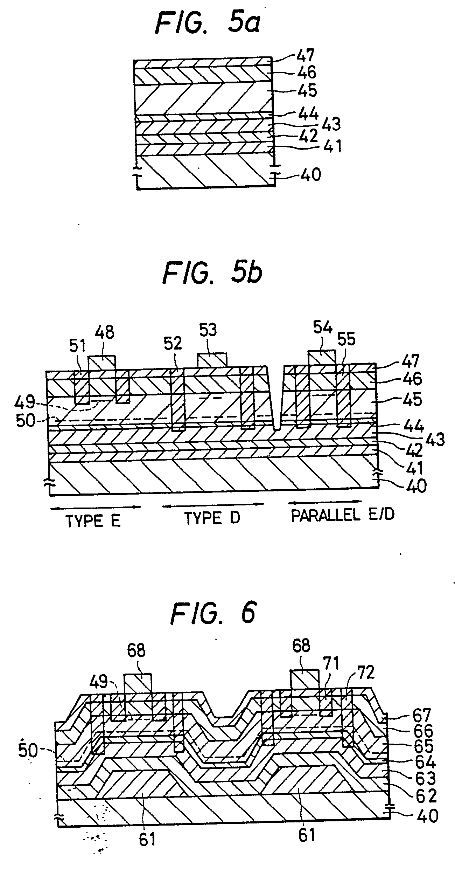

Figs. 5a and 5b show steps for fabricating an IC according to the present invention. Since, in the present invention, a sudden change is required at the interface as in the prior-art examples, the crystal growth was performed by molecular beam epitaxy (hereinafter referred to as the "MBE process").

First, as illustrated in Fig. 5a, a series of layers were grown on a semi-insulating GaAs substrate 40 by the MBE process. The first two layers 41 and 42 on the substrate are buffer layers to enhance the quality of the crystal, these layers 41, 42 being respectively a high purity GaAs layer with a thickness of 0.1 μm, and a high purity GaAlAs layer with the same thickness. Then the second semiconductor layer 43 of the present invention was grown on the layer 42 to a thickness of 70 nm, the layer 43 being an n-type GaAlAs layer doped with silicon (Si) to a doping concentration of $2\times10^{18}$ $cm^{-3}$. Then a spacer layer 44 of high purity GaAs was grown to a thickness of 6 nm, followed by the first semiconductor layer 45 of the present invention, being a high purity GaAs layer 0.5 μm thick. The third semconductor layer 46 of the present invention was then grown on the GaAs layer 45, the layer 46 being a high purity GaAlAs layer with a thickness of 60 nm. Finally an n-type GaAs layer 47 doped with Si at a doping concentration of $2\times10^{18}$ $cm^{-3}$ was formed on the high purity GaAlAs layer 46, the layer 47 being to prevent oxidation of the GaAlAs layer 46.

No carriers are induced in a channel which is formed on the upper side of the high purity GaAs layer 45 without applying a positive voltage to a gate because the adjoining GaAlAs layer 46 is not doped. Therefore, the channel formed on the upper side of the high purity GaAs layer 45 functions as an E-type element. On the other hand, a channel on the lower side is not always a D-type channel as described before, but its type depends upon the thickness and doping concentration of the adjoining GaAlAs layer 43. Therefore, the thickness, doping concentration etc. of the GaAlAs layer 43 need to be designed in advance so that carriers may be supplied from the doped GaAlAs layer 43 without applying any voltage to the gate. Thus, the channel on the lower side may function as a D-type element.

Next, mesa etching was performed as required to isolate elements of the device. As shown in Fig. 5b, mesa etching was carried out between the D-type element and the E-/D-parallel type elements. It is to be noted, however, that the mesa etching is not always necessary. Subsequently, a dummy gate 48 of $SiO_2$ was formed and, using the dummy gate 48 as a mask, Si was ion-implantated 51 as illustrated in Fig. 5b. The E-type element is ion-implanted only shallowly with donor atoms lest they should reach the lower channel when ohmic electrodes for source and drain electrodes are formed. It is only in a part directly under the gate that the carriers are induced upon the application of the gate voltage, so this ion-implantation needs to be executed in self-alignment fashion. When only an element of D-type is necessary, Si may be ion-implanted 52 deeply enough to reach the lower channel but with a separation greater than the Si 51 implanted in the E-type device. When a gate electrode 53 equal in size to the gate electrode 48 of the E-type device is formed at a later step, a gap appears between the gate electrode 53 and the ion-implanted part 52, and only an element of the D-type can be obtained in this region. This is because the channel on the upper side of the high purity GaAs layer 45 has carriers induced only in the part underneath the gate 53, no current flows and no element is formed. In addition, when ion implantation 55 is performed deeply in self-alignment fashion so as to form no gap between the ion-implanted part and a gate electrode portion 54, the upper and lower elements of both E- and D-types can be used in parallel connection. Therefore, ion implantation operations are performed several times as may be required in dependence on the types of device fabricated. In Fig. 5b, a channel of an E-type element is shown at 49, and a channel of a D-type element is shown at 50.

With the prior-art structures, it has been necessary to form the respective elements of E- and D-types individually beforehand and to thereafter connect them by wiring. It contrast, the present invention dispenses with that necessity.

After the ion implantation operations required for the respective elements were performed as described above, annealing was conducted to activate the implanted atoms. On this occasion, in order to prevent as much as possible any sag of the hetero-interface or diffusion of the implanted atoms, etc., the annealing was flash annealing at 750°C.

Subsequently, ohmic electrodes were formed on source and drain portions by the use of Au/Ge/Ni, and gate electrodes were formed by the use of Ti/Pt/Au, whereupon the respective elements were wired by the use of aluminium.

As described above, in fabricating the elements, precise etching techniques are not required, and the ion implantation is not performed in the channel parts directly under the gates. It was therefore possible to form the

elements of both E- and D-types accurately and separately such that they are not inferior in performance to the prior art devices, but are more easily fabricated. Moreover, the density of integration was made higher than in prior art devices by vertically connecting both the channels in parallel.

Example 2

Fig. 6 shows a diagram of a sectional structure where there are gate electrodes on both sides of semiconductor layers.

Gates electrodes on a substrate side were formed by first grouping an $n^+$ GaAs layer 61 doped with Sn at an impurity concentration of $2\times10^{19}$ $cm^{-3}$ on a semi-insulating GaAs substrate 40 to a thickness of 0.3 μm by the MBE process. The layer 61 was then patterned as shown.

After the patterning, respective layers were grown by the MBE process again in the following order: a high purity GaAlAs layer 62 0.05 μm thick to be used as a barrier layer; an Si-doped GaAlAs layer 63 0.07 μm thick being the second semiconductor layer of the present invention; a high purity GaAlAs layer 64 6 nm thick, a high purity GaAs layer 65 0.5 μm thick being the first semiconductor layer of the present invention; a high purity GaAlAs layer 66 0.07 μ thick, being the third semiconductor layer of the present invention; and a GaAs layer 67 0.02 μm thick for preventing oxidation.

Next, gate electrodes 68 on an upper side were formed by the use of tungsten silicide, and using them as a mask, Si was shallowly ion-implanted (parts 71) so as to connect only an upper channel thereto. Next, a mask was formed of $SiO_2$ so as to conceal completely the above implanted parts, and ion implantation (parts 72) was performed deeply so as to reach a lower channel.

At the next step, annealing was performed at 750°C so as to prevent the hetero-interface from sagging, whereby the ion-implanted atoms were activated. Thereafter, ohmic electrodes for source and drain electrodes were formed by the use of Au/Ge/Ni.

In this way, elements of both E- and D-types can be formed in the same place and can be controlled individually, so that the density of integration becomes higher than in prior art devices. Also, precise etching techniques are not required for forming E- and D-type elements accurately and separately.

Whilst a hetero-interface between GaAs and GaAlAs was employed in the above examples 1 and 2, other materials adapted to form heterojunctions can of course attain similar effects. By way of example, the materials are the compound semiconductor systems of

$Ga_{1-x}Al_xAs$-$Ga_{1-y}$-$Al_yAs$, GaAs-GaAlAsP,

InP-InGaAsP, InP-InGaAs,

InAs-GaAsSb, and InGaAs-InAlAs.

According to the present invention described above, the following advantages may be achieved:

(1) Precise etching techniques are not required to form both E- and D-type elements accurately and separately.

(2) Since ion implantation is not performed in a hetero-interface directly under a gate, the performance of an element is not degraded by ion implantation.

(3) Also, in the IC implementation, the density of integration may be enhanced because upper and lower elements can be used in the same place.

**Claims**

1. A semiconductor device having:

a first semiconductor layer (31, 45, 65) which is undoped;

a second semiconductor layer (33, 43, 63) which has a forbidden band width greater than that of the first semiconductor layer (31, 45, 65), which is doped with impurities, and which is between the first semiconductor layer (45, 65) and a substrate (40);

a third semiconductor layer (32, 46, 66) which has a forbidden band width greater than that of the first semiconductor layer, the first semiconductor layer (31, 45, 65) being between the second semiconductor layer (33, 43, 63) and the third semiconductor layer (32, 46, 66),

at least one control electrode (48, 53, 54, 61, 68) for controlling currents flowing within the first and second channels (50, 49) formed in the first semiconductor layer adjacent the interfaces of the first semiconductor layer with the second and third semiconductor layers respectively, the first channel (50) being of depletion type, the at least one control electrode being on the side of the second or third semiconductor layers remote from the first semiconductor layer; and

at least one pair of ohmic electrodes (51, 52, 55, 71, 72), the electrodes of said pair being located on either side of the at least one control electrode;

characterised in that:

the third semiconductor layer (32, 46, 66) is undoped so that the second channel (49) is of enhancement type, and the at least one pair of ohmic electrodes comprises either a first pair of ohmic electrodes (52, 72) with electrode regions extending from the third semiconductor layer to the first channel (50), and a second pair of ohmic electrodes (51, 71) with electrode regions extending from the third semiconductor layer to the second channel (49) or electrode regions (55) extending from the third semiconductor layer and connecting both channels (49, 50) in parallel.

2. A semiconductor device according to claim 1 having an oxidation-proof semiconductor layer (47) on the third semiconductor layer.

3. A semiconductor device according to claim 1 or claim 2 having a semiconductor layer (44) of the same material as that of said second semiconductor layer (43) but which is undoped, and which

is interposed between the first semiconductor layer (45) and the second semiconductor layer (43).

4. A semiconductor device according to any one of the preceding claims having at least one undoped semiconductor layer (41, 42), interposed between the second semiconductor layer (43) and the substrate (40).

5. A semiconductor device according to claim 4, wherein the undoped semiconductor layer (41, 42) between the second semiconductor layer (43) and the substrate (40) is of the same material as that of the substrate (40) or the second semiconductor layer (43).

6. A semiconductor device according to claim 4 having a semiconductor layer (41) of the same material as that of the substrate (40) and a semiconductor layer (42) of the same material as that of the second semiconductor layer (43) interposed between the substrate (40) and the second semiconductor layer (43) successively from the substrate side.

7. A semiconductor device according to any one of the preceding claims, wherein the at least one control electrode comprises first and second control electrodes (53, 48; Fig. 5b) associated respectively with the first and second pairs of ohmic electrodes (52, 51) each control electrode being on the side of the third semiconductor layer (43) remote from the first semiconductor layer (45), and being between the electrodes of the corresponding pair of ohmic electrodes.

8. A semiconductor device according to any one of claims 1 to 6, having one control electrode (61; Fig. 6) on the side of the second semiconductor layer (63) remote from the first semiconductor layer (65) for controlling currents flowing within the first channel (50) and one control electrode (68) on the side of the third semiconductor layer (66) remote from the first semiconductor layer for controlling currents flowing within the second channel (49), each control electrode (61, 68) being located between the electrodes of the corresponding pair of ohmic electrodes (72, 71).

**Patentansprüche**

1. Halbleitervorrichtung mit

einer ersten Halbleiterschicht (31, 45, 65), die undotiert ist;

einer zweiten Halbleiterschicht (33, 43, 63), die eine verbotene Bandbreite größer als die der ersten Halbleiterschicht (31, 45, 65) hat, die mit Dotierstoffen dotiert ist und die sich zwischen der ersten Halbleiterschicht (45, 65) und einem Substrate (40) befindet;

einer dritten Halbleiterschicht (32, 46, 66), die eine verbotene Bandbreite größer als die der ersten Halbleiterschicht hat, wobei sich die erste Halbleiterschicht (31, 45, 65) zwischen der zweiten Halbleiterschicht (33, 43, 63) und der dritten Halbleiterschicht (32, 46, 66) befindet;

zumindest einer Steuerelektrode (48, 53, 54, 61, 68) zum Steuern von Strömen, die in dem ersten und zweiten Kanal (50, 49) fließen, die in der ersten Halbleiterschicht angrenzend an die Grenzflächen der ersten Halbleiterschicht mit der zweiten bzw. dritten Halbleiterschicht gebildet sind, wobei der erste Kanal (50) vom Verarmungstyp ist, wobei die zumindest eine Steuerelektrode auf der Seite der zweiten oder dritten Halbleiterschicht entfernt von der ersten Halbleiterschicht liegt; und

zumindest einem Paar von Ohmschen Elektroden (51, 52, 55, 71, 72), wobei die Elektroden dieses Paares auf beiden Seiten der zumindest einen Steuerelektrode liegen;

dadurch gekennzeichnet,

daß die dritte Halbleiterschicht (32, 46, 66) undotiert ist, so daß der zweite Kanal (49) vom Anreicherungstyp ist, und daß das zumindest eine Paar von Ohmschen Elektroden entweder ein erstes Paar von Ohmschen Elektroden (52, 72) mit Elektrodenbereichen, die von der dritten Halbleiterschicht zu dem ersten Kanal (50) verlaufen, und ein zweites Paar von Ohmschen Elektroden (51, 71) mit Elektrodenbereichen, die von der dritten Halbleiterschicht zu dem zweiten Kanal (49) verlaufen, oder Eketrodenbereiche (55) aufweist, die von der dritten Halbleiterschicht ausgehen und beide Kanäle (49, 50) parallel schalten.

2. Halbleitervorrichtung nach Anspruch 1, die eine oxidationsbeständige Halbleiterschicht (47) auf der dritten Halbleiterschicht hat.

3. Halbleitervorrichtung nach Anspruch 1 oder Anspruch 2, die eine Halbleiterschicht (44) aus dem selben Material wie die zweite Halbleiterschicht (43) hat, die jedoch undotiert ist und die zwischen die erste Halbleiterschicht (45) und die zweite Halbleiterschicht (43) eingefügt ist.

4. Halbleitervorrichtung nach einem der vorhergehenden Ansprüche, die zumindest eine undotierte Halbleiterschicht (41, 42) hat, die zwischen die zweite Halbleiterschicht (43) und das Substrat (40) eingefügt ist.

5. Halbleitervorrichtung nach Anspruch 4, wobei die undotierte Halbleiterschicht (41, 42) zwischen der zweiten Halbleiterschicht (43) und dem Substrat (40) aus dem selben Material wie das Substrat (40) oder wie die zweite Halbleiterschicht (43) ist.

6. Halbleitervorrichtung nach Anspruch 4, die eine Halbleiterschicht (41) aus dem selben Material wie das Substrat (40) und eine Halbleiterschicht (42) aus dem selben Material wie die zweite Halbleiterschicht (43) hat, die von der Substratseite aus nacheinander zwischen das Substrat (40) und die zweite Halbleiterschicht (43) einegefügt sind.

7. Halbleitervorrichtung nach einem der vorhergehenden Ansprüche, woebei die zumindest eine Steuerelektrode erste und zweite Steuerelektroden (53, 48; Figur 5b) aufweist, die jeweils den ersten und zweiten Paaren von Ohmschen Elektroden (52, 51) zugeordnet sind, wobei sich jede Steuerelektrode auf der Seite der dritten Halbleiterschicht (43) entfernt von der ersten Halbleiterschicht (45) und zwischen den Elektroden des entsprechenden Paars von Ohmschen Elektroden befindet.

8. Halbleitervorrichtung nach einem der Ansprüche 1 bis 6 mit einer Steuerelektrode (61; Figur 6) auf der Seite der zweiten Halbleiterschicht (63) entfernt von der ersten Halbleiterschicht (65) zum Steuern von in dem ersten Kanal (50) fließenden Strömen und mit einer Steuerelektrode (68) auf der Seite der dritten Halbleiterschicht (66) entfernt von der ersten Halbleiterschicht zum Steuern von in dem zweiten Kanal (49) fließenden Strömen, wobei jede Steuerelektrode (61, 68) zwischen den Elektroden des entsprechenden Paares von Ohmschen Elektroden (72, 71) liegt.

**Revendications**

1. Dispositif à semiconducteurs possédant:

une première couche semiconductrice (31, 45, 65) non dopée;

une seconde couche semiconductrice (33, 43, 63) qui possède une largeur de bande interdite supérieure à celle de la première couche semiconductrice (31, 45, 65), qui est dopée avec des impuretés, et qui se trouve entre la première couche semiconductrice (45, 65) et un substrat (40);

une troisième couche semiconductrice (32, 46, 66) qui possède une largeur de bande interdite supérieure à celle de la première couche semiconductrice, la première couche semiconductrice (31, 45, 65) se trouvant entre la seconde couche semiconductrice (33, 43, 63) et la troisième couche semiconductrice (32, 46, 66),

au moins une électrode de commande (48, 53, 54, 61, 68) pour commander des courants circulant dans les premier et second canaux (50, 49) formés dans la première couche semiconductrice adjacents aux interfaces de la première couche semiconductrice avec les seconde et troisième couches semiconductrices respectivement, le premier canal (50) étant du type à appauvrissement, la ou les électrodes de commande étant sur le côté des seconde ou troisième couches semiconductrices éloigné de la première couche semiconductrice; et

au moins une paire d'électrodes ohmiques (51, 52, 55, 71, 72), les électrodes de ladite paire étant situées de part et d'autre de la ou les électrodes de commande,

caractérisé en ce que:

la troisième couche semiconductrice (32, 46, 66) n'est pas dopée de sorte que le second canal (49) est du type à enrichissement, et la ou les paires d'électrodes ohmiques comportent soit une première paire d'électrodes ohmiques (52, 72) avec des régions d'électrode s'étendant depuis la troisième couche semiconductrice jusqu'au premier canal (50), et une seconde paire d'électrodes ohmiques (51, 71) avec des régions d'électrode s'étendant depuis la troisième couche semiconductrice jusqu'au second canal (49) soit des régions d'électrode (55) s'étendant depuis la troisième couche semiconductrice et reliant les deux canaux (49, 50) en parallèle.

2. Dispositif à semiconducteurs selon la revendication 1, possédant une couche semiconductrice résistant à l'oxydation (47) sur la troisième couche semiconductrice.

3. Dispositif à semiconducteurs selon la revendication 1 ou la revendication 2, possédant une couche semiconductrice (44) en même matériau que celui de ladite seconde couche semiconductrice (43) mais qui n'est pas dopée, et qui est interposée entre la première couche semiconductrice (45) et la seconde couche semiconductrice (43).

4. Dispositif à semiconducteurs selon l'une quelconque des revendications précédentes, possédant au moins une couche semiconductrice non dopée (41, 42) interposée entre la seconde couche semiconductrice (43) et le substrat (40).

5. Dispositif à semiconducteurs selon la revendication 4, dans lequel la couche semiconductrice non dopée (41, 42) entre la seconde couche semiconductrice (43) et le substrat (40) est en même matériau que celui du substrat (40) ou de la seconde couche semiconductrice (43).

6. Dispositif à semiconducteurs selon la revendication 4 possédant une couche semiconductrice (41) en même matériau que celui du substrat (40) et une couche semiconductrice (42) en même matériau que celui de la seconde couche semiconductrice (43) interposée entre le substrat (40) et la seconde couche semiconductrice (43) successivement à partir du côté du substrat.

7. Dispositif à semiconducteurs selon l'une quelconque des revendications précédentes, dans lequel les électrodes de commande comportent des première et seconde électrodes de commande (53, 48; Fig. 5b) associées respectivement auxdites première et seconde paires d'électrodes ohmiques (52, 51), chaque électrode de commande étant sur le côté de la troisième couche semiconductrice (43) éloigné de la première couche semiconductrice (45) et se trouvant entre les électrodes de la paire correspondante d'électrodes ohmiques.

8. Dispositif à semiconducteurs selon l'une quelconque des revendications 1 à 6, possédant une électrode de commande (61; Fig. 6) sur le côté de la seconde couche semiconductrice (63) éloigné de la première couche semiconductrice (65) pour commander des courants circulant à l'intérieur du premier canal (50) et une électrode de commande (62) sur le côté de la troisième couche semiconductrice (66) éloigné de la première couche semiconductrice pour commander des courants circulant à l'intérieur du second canal (49), chaque électrode de commande (61, 68) étant située entre les électrodes de la paire correspondante d'électrodes ohmiques (72, 71).

FIG. 1

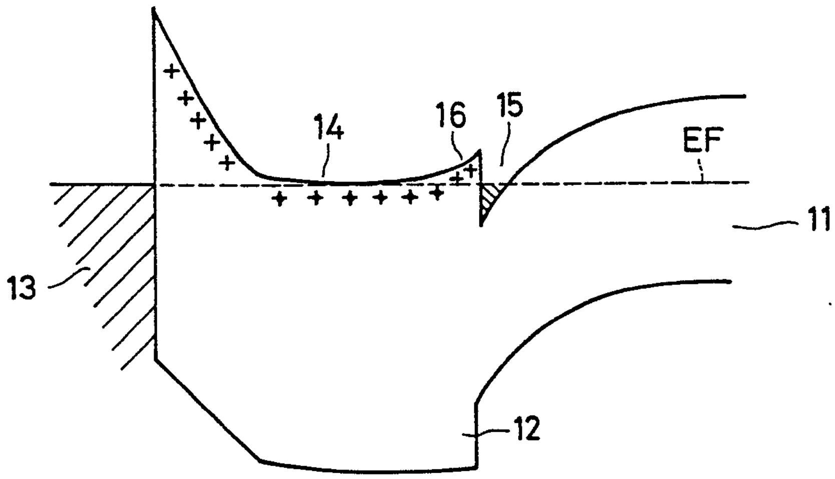


FIG. 2

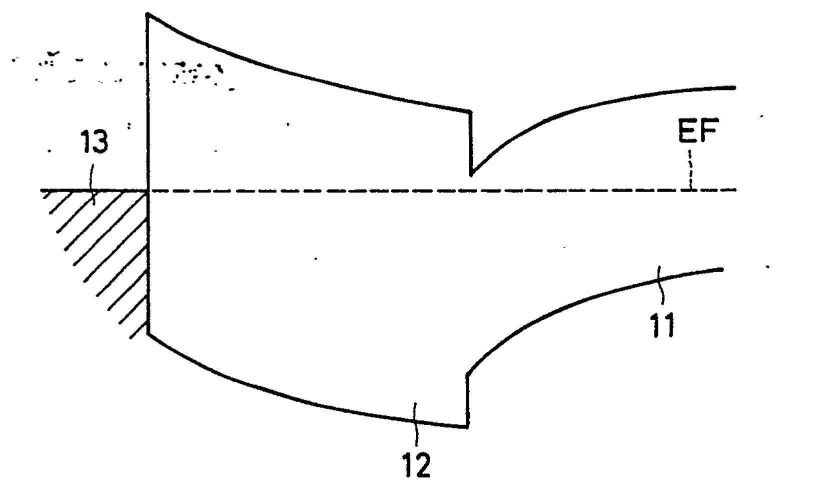

FIG. 3

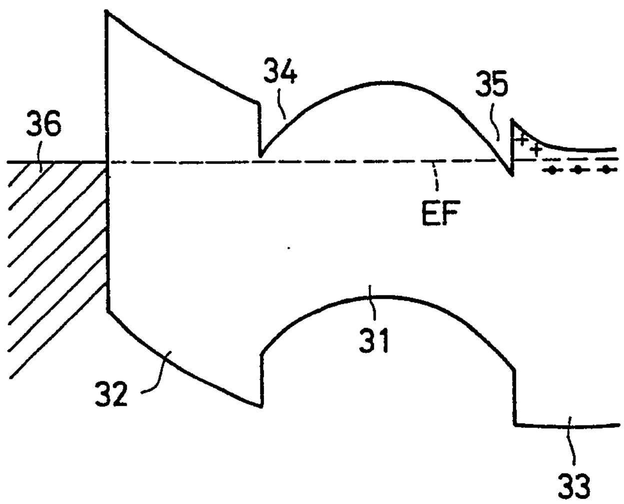


FIG. 4

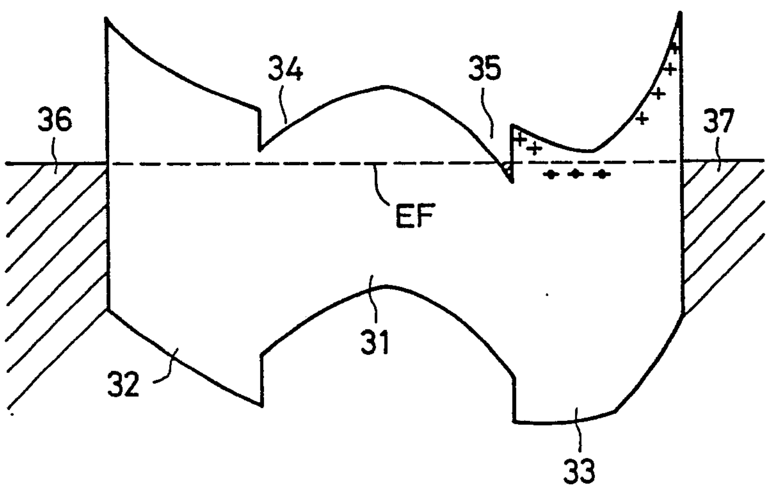

FIG. 5a

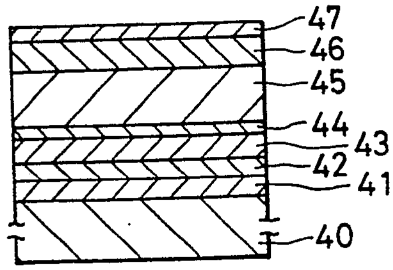


FIG. 5b

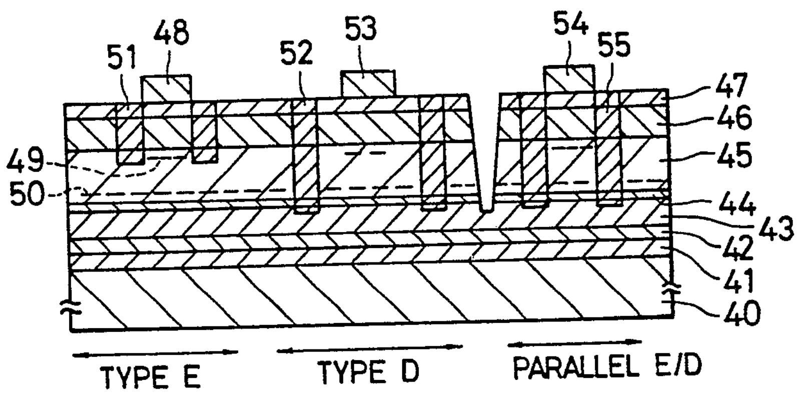


FIG. 6